# EUROPÄISCHE PATENTSCHRIFT

(11) **EP 2 815 451 B1**
(45) Veröffentlichungstag und Bekanntmachung des Hinweises auf die Patenterteilung: **14.03.2018**
(21) Anmeldenummer: 13700654.0
(22) Anmeldetag: 10.01.2013
(51) Int. Cl.: H01M 10/42, H01M 10/48, H04Q 9/00, G01R 31/36

(54) **VERFAHREN ZUM ÜBERWACHEN EINER BATTERIE**
METHOD FOR MONITORING A BATTERY
PROCÉDÉ DE SURVEILLANCE D'UNE BATTERIE

(30) Priorität: 13.02.2012 DE 102012202079
(43) Veröffentlichungstag der Anmeldung: 24.12.2014
(73) Patentinhaber: Robert Bosch GmbH, 70442 Stuttgart (DE)
(72) Erfinder: STEINLECHNER, Siegbert, 71229 Leonberg (DE); HENRICI, Fabian, 70195 Stuttgart (DE)
(86) Internationale Anmeldenummer: PCT/EP2013/050363
(87) Internationale Veröffentlichungsnummer: WO 2013/120637

(56) Entgegenhaltungen:
- US-A1- 2002 163 339
- US-A1- 2009 265 121
- US-A1- 2011 068 746

## Beschreibung

Die Erfindung betrifft ein Verfahren zum Überwachen einer Batterie, eine Batterie, die zur Durchführung des Verfahrens ausgebildet ist, und eine Anordnung, die in einer solchen Batterie zur Durchführung des vorgestellten Verfahrens zur Anwendung kommt.

### Stand der Technik

Eine Batterie ist eine Zusammenschaltung mehrerer in der Regel gleichartiger galvanischer Zellen und stellt einen elektrochemischen Energiespeicher und einen Energiewandler dar, der zur Abgabe elektrischer Energie vorgesehen ist. Hierzu wird in der Batterie bei der Entladung gespeicherte chemische Energie durch die elektrochemische Reaktion in elektrische Energie umgewandelt. Dabei sind die Zellen der Batterie, die parallel oder in Reihe oder gemischt geschaltet sein können, in sogenannten Modulen angeordnet. Eines oder mehrere dieser Module, in Reihe oder parallel geschaltet, bilden die Batterie.

Bei den genannten Zellen wird zwischen Primärzellen, die nicht wiederaufladbar sind, und Sekundärzellen, die wiederaufladbar sind, unterschieden. Eine wiederaufladbaren Batterie wird auch als Akkumulator mit Akkuzellen bezeichnet. Im folgenden wird unter Batterie sowohl eine nicht wiederaufladbare als auch eine wiederaufladbare Batterie verstanden.

Batterien kommen bspw. in Kraftfahrzeugen zur Bereitstellung des elektrischen Stroms für den Anlasser des Verbrennungsmotors zum Einsatz. Eine solche Batterie wird als Starterbatterie bezeichnet und ist bspw. als Bleiakkumulator ausgebildet. Neben der Versorgung des Anlassers versorgt die Batterie auch die anderen elektrischen Verbraucher im Fahrzeug. Zum Anlassen des Verbrennungsmotors sind kurzzeitig hohe Ströme erforderlich, die auch bei niedrigen Temperaturen bereitgestellt werden müssen.

In Elektrofahrzeugen oder Hybridfahrzeugen werden Batterien auch als Energiequellen für den Antrieb des Fahrzeugs verwendet. Diese werden auch als Traktionsbatterien bezeichnet.

In jedem Fall ist es erforderlich, die Funktionsfähigkeit der Batterie im Fahrzeug regelmäßig oder gar kontinuierlich zu überwachen, um einen sicheren Betrieb des Kraftfahrzeugs zu gewährleisten. Hierzu werden Kenn- bzw. Betriebsgrößen der Batterie, wie bspw. Klemmenspannung, Temperatur, Druck, insbesondere Zellinnendruck, Strom, Impedanz usw., aufgenommen.

Es ist bekannt, zur Überwachung und Kommunikation Sensoren in der Batterie einzusetzen. Weiterhin ist es bekannt, innerhalb der Batterie Sensorsignale über dafür vorgesehene Datenleitungen, bspw. den CAN-Bus, der typischerweise in Kraftfahrzeugen eingesetzt wird, zu erfassen.

In der Druckschrift WO 2009/149690 A1 sind eine Batterie mit Batteriezellen und ein Verfahren zum Überwachen der Batterie beschrieben. Die vorgestellte Batterie weist eine Vielzahl von Batteriezellenstapeln auf, wobei ein Batteriezellenstapel eine einzige Batteriezelle aufweist oder aus parallel geschalteten Batteriezellen aufgebaut sein kann. Sensoren überwachen den Ladezustand einzelner Batteriezellen. Der beschriebenen Batterie ist eine Ladungsausgleichseinrichtung zugeordnet, die eine Zielwerttabelle des zulässigen Ladezustands einzelner Batterien aufweist. In Abhängigkeit des Ladezustands variiert die Ladungsausgleichseinrichtung mit dem Ladezustand.

Bei Erreichen des Zielwerts für den Ladezustand einzelner Batteriezellen wird der Ladungsausgleich der Batteriezellen unterbrochen. An jeder Batteriezelle ist ein Abgriff einer Ladungsausgleichsleitung angeordnet, wobei die Ladungsausgleichsanordnungen in einem Kabelbaum vereinigt sind und vorgesehenen Zellenüberwachungsmodulen zugeführt werden, die ihrerseits Sensoren und Zellüberwachungsschaltkreise aufweisen, wobei diese Komponenten der Zellüberwachung gemeinsam in der Ladungsausgleichseinrichtung räumlich von den Batteriezellen getrennt, angeordnet sind.

Aus der Druckschrift US 2011/0068746 A1 ist ein Verfahren zum Überwachen einer Batterie, der eine Anzahl von Sensoren zugeordnet ist, bekannt. Dabei sind die Sensoren über eine Datenleitung seriell miteinander und mit einem Steuergerät verbunden. Mindestens einer der Sensoren misst jeweils mindestens eine Größe, die einen Funktionszustand der Batterie betrifft, und gibt die dabei gewonnenen Messdaten auf die Datenleitung zur Übermittlung an das Steuergerät. Ein ähnliches Verfahren ist jeweils auch aus der Druckschrift US 2009/0265121 A1 und aus der Druckschrift US 202/0163339 A1 bekannt. Die aus der Druckschrift US 202/0163339 A1 bekannte Steuereinheit ist ferner dazu ausgebildet, den mindestens einen Sensor derartig anzusteuern, dass dieser zu vordefinierten Zeitpunkten die mindestens eine Größe misst.

### Offenbarung der Erfindung

Vor diesem Hintergrund werden ein Verfahren zum Überwachen einer Batterie nach Anspruch 1 und eine entsprechende Anordnung zum Überwachen einer Batterie gemäß Anspruch 8 vorgestellt. Ausgestaltungen ergeben sich aus den abhängigen Ansprüchen und der Beschreibung.

Mit dem vorgestellten Verfahren kann eine Kommunikation zwischen Batteriesensoren an Batteriezellen und zu einem zentralen Steuergerät durchgeführt werden.

Bislang ist die Anbringung oder Einbringung von Batteriesensoren in einem Sensorsystem an oder in Batteriezellen von Hybrid- und Elektrofahrzeugen bekannt. Typischerweise sind das 100 oder mehr Zellen, von denen jede mit einem Batteriesensor versehen sein kann. Zwischen diesen Sensoren und einem zentralen Steuergerät müssen Messdaten und Steuerbefehle uni- oder bidirektional ausgetauscht werden.

Es wird nunmehr die Verwendung einer seriellen Kommunikation zwischen den einzelnen Sensoren beschrieben. Jeder Sensor übermittelt in Ausgestaltung seine Daten bzw. ein Datenwort an den nächsten, dieser fügt seine Daten hinzu und reicht das Gesamtpaket an den nächsten Sensor weiter. Das Steuergerät ist am Ende der Kette angeschlossen und erhält ein Datengesamtpaket mit den Daten aller Sensoren. Somit gibt jeder Sensor ein ihm zugeordnetes Datenwort auf die Datenleitung. Alle Datenwörter bilden aneinandergefügt das Datengesamtpaket. In der anderen Richtung ist ein Rückkanal vom Steuergerät zum ersten Sensor in der Kette vorgesehen. Dann wandern die Daten und/oder Steuersignale ebenfalls die Kette durch, bis sie von allen Sensoren empfangen wurden. Die Sensoren können sich außerhalb oder innerhalb der Zelle befinden. Im letzteren Fall ist eine Durchführung für zwei zusätzliche Drähte notwendig. Ist ein Rückkanal vorgesehen, können die Datenwörter bzw. das Datengesamtpaket "im Kreis laufen" und auch wieder von den jeweiligen Sensoren überschrieben werden.

Bei dem vorgestellten Verfahren ist vorgesehen, dass mindestens einer der Sensoren jeweils wenigstens ein Datenwort auf die Datenleitung gibt. Dabei können die Datenwörter zu einem Datengesamtpaket aneinandergefügt werden und das Datengesamtpaket über die Datenleitung zu dem Steuergerät gesendet werden.

In einer Ausführung wird ein erstes Datenwort von einem Sensor über die Datenleitung zu einem nächsten Sensor gesendet wird, von dem nächsten Sensor ein weiteres Datenwort an das erste Datenwort angefügt wird und dies solange durchgeführt wird, bis ein Datengesamtpaket, das Datenwörter sämtlicher Sensoren enthält, zu dem Steuergerät gelangt.

Sollte vorab bekannt sein, wie groß das vom Steuergerät zu empfangene Datenpaket ist, kann alternativ vorgesehen sein, dass ein erstes Datenwort von einem Sensor auf die Datenleitung gegeben wird und dieses zu dem Steuergerät übermittelt wird und nach einem vorbestimmten Zeitraum ein nächster Sensor ein zweites Datenwort auf die Datenleitung gibt. In diesem Fall kann der erste Sensor bspw. ein "normales" RS232-Datenpaket mit z.B. 8 Bit Inhalt senden und dann eine Pause vorsehen, bspw. 200 * der Zeitraum, der für die Übermittlung zum Steuergerät erforderlich ist. Der nächste bzw. zweite Sensor hängt dann sein Datenwort dahinter usw. Dann erhält das Steuergerät z.B. einhundert 8 Bit Datenpakete, die es mit einem üblichen RS232-Empfänger (UART) nacheinander empfangen kann.

Das vorgestellte Verfahren hat, zumindest in einigen der Ausführungen, wesentliche Vorteile:
1. Das vorgestellte Verfahren stellt eine kostengünstige Vorgehensweise dar, da lediglich zwei Anschlüsse pro Sensor und nur eine Eindrahtverbindung zwischen den Sensoren benötigt wird.
2. Jeder Sensor sieht nur die Spannungsdifferenz zu seinem direkten Nachbarn, also plus oder minus 4 V, dies ist im Gegensatz zur vollen Gesamtspannung aller Zellen (∼ 400 V), die bei einem parallelen Anschluss anliegen würde, mit Standard-CMOS Technologie einfach umzusetzen.
3. Der serielle Anschluss erleichtert die Identifikation der einzelnen Zellen, es ist einfach festzustellen, ob ein Batteriesensor zum Beispiel an der 35. Stelle in der Kette sitzt.
4. Es muss nur ein einziges Bit zur Warnung vor unerwünschten Betriebszuständen, bspw. Erreichen der Ladeschlussspannung, übertragen werden. Jeder Sensor überträgt das "OK"-Signal des Vorgängers weiter oder ändert es zu einem "Nicht OK"-Signal um, falls sein eigener Zustand kritisch ist.

Das beschriebene Verfahren ist für alle Anwendungen einsetzbar, bei denen Kenngrößen, wie bspw. die Temperatur, im Betrieb gemessen werden müssen. Besonders geeignet ist das Verfahren für den Einsatz bei Batterien in Kraftfahrzeugen, insbesondere in Elektrofahrzeugen.

Neben der Temperatur kann bspw. auch die Zellspannung gemessen werden. Die Auswertung kann dann in dem angeschlossenen Steuergerät erfolgen. Eine weitere mögliche Funktion, die unterstützt werden kann, ist das sogenannte cell balancing.

Die Sensoren, die die Messgrößen aufnehmen, können in Kontakt mit zugeordneten Batteriemodulen oder Batteriezellen sein, d.h. die Sensoren sind an oder in den Modulen bzw. Zellen angeordnet. Dabei kann jedem Modul oder auch jeder Zelle ein Sensor zugeordnet sein. Die Sensoren können dann mindestens eine Messgröße und/oder eine Information, bspw. "OK" und "Nicht-OK", zum Zustand des zugeordneten Moduls oder der zugeordneten Zelle geben.

Weitere Vorteile und Ausgestaltungen der Erfindung ergeben sich aus der Beschreibung und den beiliegenden Zeichnungen.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Kurze Beschreibung der Zeichnungen

- Figur 1: zeigt eine Ausführung der beschriebenen Batterie in einer schematischen Darstellung.
- Figur 2: zeigt eine Ausführungsform des beschriebenen Verfahrens in einem Flussdiagramm.

### Ausführungsformen der Erfindung

Die Erfindung ist anhand von Ausführungsformen in den Zeichnungen schematisch dargestellt und wird nachfolgend unter Bezugnahme auf die Zeichnungen ausführlich beschrieben.

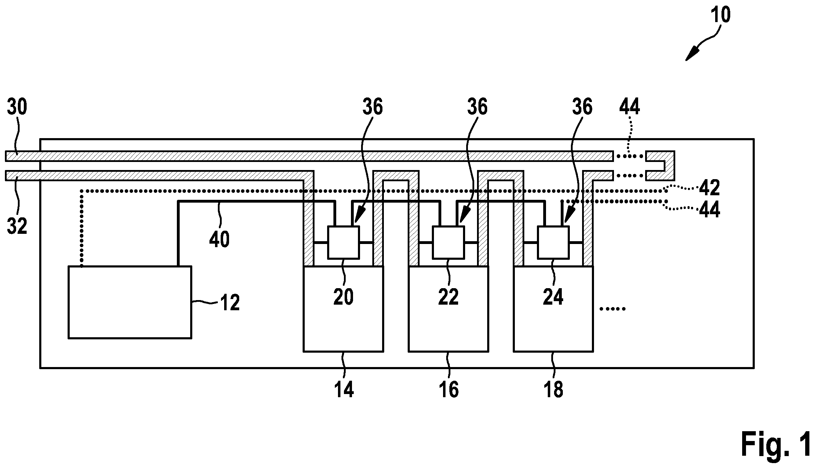

In Figur 1 ist eine Ausführung der vorgestellten Batterie, insgesamt mit der Bezugsziffer 10 bezeichnet, wiedergegeben. Die Darstellung zeigt ein Steuergerät 12, eine erste Zelle 14, eine zweite Zelle 16 und eine dritte Zelle 18. In der Darstellung sind der Übersichtlichkeit wegen nur drei Zellen 14, 16 und 18 gezeigt, es können selbstverständlich auch mehr Zellen 14, 16, 18 vorgesehen sein, die wiederum in Modulen gruppiert sein können. Die einzelnen Zellen wiederum können eine Anzahl galvanischer Zellen umfassen.

Der ersten Zelle 14 ist ein erster Sensor 20, der zweiten Zelle 16 ein zweiter Sensor 22 und der dritten Zelle 18 ein dritter Sensor 24 zugeordnet. In dieser Ausführung ist jeder Zelle 14, 16 und 18 genau ein Sensor 20, 22 bzw. 24 zugeordnet. Es sind aber auch andere Ausführungen denkbar, bei denen Sensoren 20, 22, 24 nur einigen der Zellen 14, 16, 18, galvanischen Zellen, Modulen und auch nur einigen der Modulen zugeordnet sind. Die Zellen 14, 16, 18 sind bei dieser Ausführung in Reihe geschaltet und können wiederum eine Parallel-und/oder Reihenschaltung galvanischer Zellen umfassen.

Weiterhin zeigt die Darstellung zwei Stromschienen 30 und 32, über die die Zellen 14, 16 und 18 angeschlossen sind und über die auch die Sensoren 20, 22 und 24 versorgt werden können. Die Sensoren 20, 22, 24 können auch jeweils aus der zugeordneten Zelle 14, 16, 18 oder durch eine dezidierte Versorgungsleitung versorgt werden. Weiterhin ist eine serielle Datenleitung 40 gezeigt, über die die Sensoren 20, 22 und 24 seriell bzw. der Reihe nach angeschlossen sind. An einem Ende der seriellen Verbindung ist das Steuergerät 12 angeschlossen. Die Sensoren 20, 22 und 24 sind über serielle Sensorschnittstellen 36 mit der seriellen Datenleitung 40 verbunden. Zur weiteren Verdeutlichung zeigt die Darstellung außerdem einen optionalen Rückkanal 42 und eine Verbindung 44 zur nächsten Zelle, die in dieser Darstellung nicht gezeigt ist.

Die serielle Datenleitung 40, die Sensorschnittstellen 36, die Sensoren 20, 22 und 24 und das Steuergerät 12 stellen eine Anordnung 50 dar, die eine serielle Kommunikation zwischen einzelnen Zellen 14, 16 und 18 ermöglicht. Hierzu kann jeder Sensor 20, 22 und 24 ein Datenwort an den nächsten Sensor 20, 22 und 24 übermitteln. Dieser fügt dann sein Datenwort zu dem übertragenen Datenpaket hinzu und reicht dieses zum nächsten Sensor 20, 22 und 24 weiter. Das Steuergerät 12 am Ende der Kette erhält Informationen zu allen Sensoren 20, 22 und 24 bzw. Zellen 14, 16 und 18. Der vorgesehene Rückkanal 42 von dem Steuergerät 12 zu dem ersten Sensor 20 und von diesem weiter dient dazu, Daten, bspw. Steuersignale oder Konfigurationsdateien, zu den Sensoren 20, 22 und 24 zu senden.

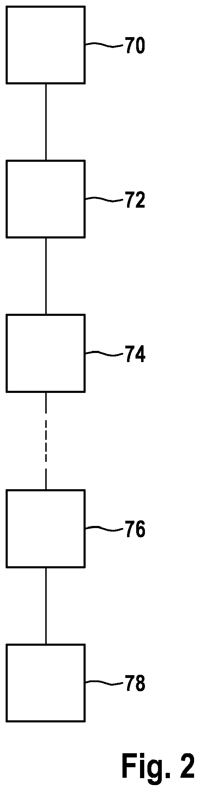

In Figur 2 ist in einem Flussdiagramm eine mögliche Ausführung des Verfahrens vorgestellt, dass grundsätzlich eine Kommunikation zwischen Sensoren in einer Batterie bzw. zwischen Teilen, wie bspw. Zellen oder Modulen, der Batterie ermöglicht und daher zur Überwachung dieser Batterie eingesetzt werden kann.

In einem ersten Schritt 70 gibt ein erster Sensor einen Messwert, der von einer zugeordneten Zelle erfasst wurde und Auskunft zum Betriebszustand und ggf. zur Funktionsfähigkeit dieser Zelle gibt, über eine serielle Sensorschnittstelle auf eine serielle Datenleitung. Dieser Messwert bzw. ein diesen repräsentierendes Datenwort wird zu einem weiteren, seriell angeordneten Sensor über die serielle Datenleitung in einem weiteren Schritt 72 gesendet, der wiederum dem empfangenen Datenpaket in einem weiteren Schritt 74 ein entsprechendes Datenwort anfügt.

Dieser Vorgang wiederholt sich solange, bis alle Sensoren, die seriell über die Datenleitung verbunden sind, Daten dem Datenpaket angefügt bzw. beigefügt haben. Abschließend wird das gesamte Datenpaket bzw. das Datengesamtpaket an ein Steuergerät, als die letzte Komponente in der Reihe, in einem Schritt 76 gegeben, das das Gesamtdatenpaket in einem abschließenden Schritt 78 auswertet und dabei in dem Datenpaket enthaltene Daten den Sensoren in der Reihe genau zuordnen kann.

## Patentansprüche

1. Verfahren zum Überwachen einer Batterie (10), der eine Anzahl von Sensoren (20, 22, 24) zugeordnet ist, wobei die Sensoren (20, 22, 24) über eine Datenleitung (40) seriell miteinander und mit einem Steuergerät (12) verbunden sind, wobei mindestens einer der Sensoren (20, 22, 24) jeweils wenigstens ein Datenwort auf die Datenleitung (40) zur Übermittlung an das Steuergerät (12) gibt, **dadurch gekennzeichnet, dass** die Datenwörter über einen Rückkanal (42) wieder zu den Sensoren (20, 22, 24) gelangen und jeweils von dem zugeordneten Sensor (20, 22, 24) überschrieben werden können.

2. Verfahren nach Anspruch 1, bei dem die Datenwörter zu einem Datengesamtpaket aneinandergefügt werden und das Datengesamtpaket über die Datenleitung (40) zu dem Steuergerät (12) gesendet wird.

3. Verfahren nach Anspruch 2, bei dem ein erstes Datenwort von einem Sensor (20, 22, 24) über die Datenleitung (40) zu einem nächsten Sensor (20, 22, 24) gesendet wird, von dem nächsten Sensor (20, 22, 24) ein weiteres Datenwort an das erste Datenwort angefügt wird und dies solange durchgeführt wird, bis ein Datengesamtpaket, das Datenwörter sämtlicher Sensoren enthält, zu dem Steuergerät (12) gelangt.

4. Verfahren nach Anspruch 1, bei dem ein erstes Datenwort von einem Sensor (20, 22, 24) auf die Datenleitung (40) gegeben wird und dieses zu dem Steuergerät (12) übermittelt wird und nach einem vorbestimmten Zeitraum ein nächster Sensor (20, 22, 24) ein zweites Datenwort auf die Datenleitung gibt.

5. Verfahren nach einem der Ansprüche 1 bis 4, bei dem das Steuergerät (12) das Datengesamtpaket auswertet und dabei einzelne Datenwörter den betreffenden Sensoren (20, 22, 24) zuordnet.

6. Verfahren nach einem der Anspruch 5, bei dem ein einzelner Sensor (20, 22, 24) hinsichtlich seines mechanischen Orts identifiziert wird.

7. Verfahren nach einem der Ansprüche 1 bis 6, bei dem als Datenwort ein einzelnes Bit übertragen wird.

8. Anordnung zum Überwachen einer Batterie (10) mit einer Anzahl an Sensoren (20, 22, 24), die über eine Datenleitung (40) seriell miteinander und mit einem Steuergerät (12) verbunden sind, wobei mindestens einer der Sensoren (20, 22, 24) jeweils wenigstens ein Datenwort auf die Datenleitung (40) zur Übermittlung an das Steuergerät (12) gibt, **dadurch gekennzeichnet, dass** die Datenwörter über einen Rückkanal (42) der Anordnung wieder zu den Sensoren (20, 22, 24) gelangen und jeweils von dem zugeordneten Sensor (20, 22, 24) überschrieben werden können.

## Claims

1. Method for monitoring a battery (10) that has an associated number of sensors (20, 22, 24), wherein the sensors (20, 22, 24) are connected in series with one another and to a controller (12) via a data line (40), wherein at least one of the sensors (20, 22, 24) puts at least one respective data word onto the data line (40) for transmission to the controller (12), **characterized in that** the data words reach the sensors (20, 22, 24) again via a return channel (42) and can each be overwritten by the associated sensor (20, 22, 24).

2. Method according to Claim 1, in which the data words are joined together to form a total data packet and the total data packet is sent to the controller (12) via the data line (40).

3. Method according to Claim 2, in which a first data word is sent from one sensor (20, 22, 24) via the data line (40) to a next sensor (20, 22, 24), a further data word is joined to the first data word by the next sensor (20, 22, 24) and this is performed until a total data packet that contains data words from all of the sensors reaches the controller (12).

4. Method according to Claim 1, in which a first data word is put onto the data line (40) by a sensor (20, 22, 24) and this first data word is transmitted to the controller (12), and after a predetermined period a next sensor (20, 22, 24) puts a second data word onto the data line.

5. Method according to one of Claims 1 to 4, in which the controller (12) evaluates the total data packet and in so doing associates individual data words with the relevant sensors (20, 22, 24).

6. Method according to one of Claim 5, in which a single sensor (20, 22, 24) is identified in terms of its mechanical location.

7. Method according to one of Claims 1 to 6, in which the data word transmitted is a single bit.

8. Arrangement for monitoring a battery (10) having a number of sensors (20, 22, 24) that are connected in series with one another and to a controller (12) via a data line (40), wherein at least one of the sensors (20, 22, 24) puts at least one respective data word onto the data line (40) for transmission to the controller (12), **characterized in that** the data words reach the sensors (20, 22, 24) again via a return channel (42) and can each be overwritten by the associated sensor (20, 22, 24).

## Revendications

1. Procédé de surveillance d'une batterie (10) à laquelle plusieurs capteurs (20, 22, 24) sont associés,
les capteurs (20, 22, 24) étant reliés en série les uns aux autres et à un appareil de commande (12) par un conducteur de données (40),
au moins l'un des capteurs (20, 22, 24) délivrant au moins un mot de données sur le conducteur de données (40) pour sa transmission à l'appareil de commande (12),
**caractérisé en ce que**
les mots de données reviennent aux capteurs (20, 22, 24) par un canal de retour (42) et peuvent être écrasés par le capteur (20, 22, 24) associé.

2. Procédé selon la revendication 1, dans lequel les mots de données sont concaténés en un paquet global de données et en ce que le paquet global de données est envoyé à l'appareil de commande (12) par le conducteur de données (40).

3. Procédé selon la revendication 2, dans lequel un premier mot de données est envoyé par un capteur (20, 22, 24) par le conducteur de données (40) vers un capteur de données (20, 22, 24) suivant, un autre mot de données est joint au premier mot de données par le capteur (20, 22, 24) suivant et cette opération est exécutée jusqu'à ce qu'un paquet global de données qui contient les mots de données de tous les capteurs se rende vers l'appareil de commande (12).

4. Procédé selon la revendication 1, dans lequel un premier mot de données est délivré par un capteur (20, 22, 24) sur le conducteur de données (40) et est transmis à l'appareil de commande (12) et dans lequel un capteur suivant (20, 22, 24) délivre un deuxième mot de données sur le conducteur de données après une durée prédéterminée.

5. Procédé selon l'une des revendications 1 à 4, dans lequel l'appareil de commande (12) évalue le paquet global de données et associe les différents mots de données aux capteurs (20, 22, 24) concernés.

6. Procédé selon l'une de la revendication 5, dans lequel le site mécanique d'un seul capteur (20, 22, 24) est identifié.

7. Procédé selon l'une des revendications 1 à 6, dans lequel un seul bit est transmis comme mot de données.

8. Ensemble de surveillance d'une batterie (10) présentant plusieurs capteurs (20, 22, 24) reliés en série les uns aux autres et à un appareil de commande (12) par un conducteur de données (40),
au moins l'un des capteurs (20, 22, 24) délivrant au moins un mot de données sur le conducteur de données (40) pour sa transmission à l'appareil de commande (12),
**caractérisé en ce que**
les mots de données reviennent aux capteurs (20, 22, 24) par un canal de retour (42) et peuvent être écrasés par le capteur (20, 22, 24) associé.
